# EUROPEAN PATENT APPLICATION

(11) **EP 4 679 503 A1**
(43) Date of publication of application: **14.01.2026**
(21) Application number: 24767092.0
(22) Date of filing: 03.03.2024
(51) Int. Cl.: H01L 23/36, H05K 1/02, H05K 7/20

(54) **SUBSTRATE**

(30) Priority: 03.03.2023 JP 2023033259
(71) Applicant: Itabashi Seiki Co,. Ltd., Tokyo, 170-0011 (JP)
(72) Inventor: TADA, Tetsuya, Tokyo 170-0011 (JP); KUHARA, Kenji, Tokyo 170-0011 (JP); MIMURO, Takeshi, Tokyo 170-0011 (JP)
(74) Representative: Schön, Christoph
(86) International application number: PCT/JP2024/007927
(87) International publication number: WO 2024/185724

(57) **Abstract**

[Problem] To provide a substrate that efficiently dissipates heat of an electronic component mounted on the substrate.

[Solution] This substrate is characterized by comprising a thermal diffusion circuit in which heat is caused to flow by means of a temperature difference, and an insulator, wherein: the thermal diffusion circuit includes a first base and a second base, the first base and the second base constituting an integral structure without a connecting surface; the first base is disposed on the side (upper side) on which an electronic component is disposed; the second base is disposed on the opposite side (lower side) from the side on which the electronic component is disposed; the second base is structured to extend beyond the first base in a planar direction; and the insulator is disposed on the side (upper side) of the first base where the electronic component is disposed.

## Description

### TECHNICAL FIELD

The present invention relates to a substrate that dissipates heat generated in an electronic component mounted on the substrate.

### BACKGROUND ART

Patent Document 1 and Patent Document 2 disclose a substrate in which a columnar member called a copper inlay is disposed immediately below an electronic component of the substrate at the inside of a through-hole in a plate thickness direction of the substrate to dissipate heat from the electronic component to a surface opposite to the substrate.

### CITATION LIST

### PATENT DOCUMENT

Patent Document 1: JP 2020-102506 A
Patent Document 2: JP 2005-051088 A

### DISCLOSURE OF THE INVENTION

### PROBLEM TO BE SOLVED BY THE INVENTION

In recent years, an electronic component through which a large current flow is mounted on a substrate in many cases, and as a result, there is a demand for a substrate having a structure that can efficiently dissipate heat generated in the electronic component.

Here, an object of the invention is to provide a substrate that efficiently dissipates heat from an electronic component mounted on a substrate, and a method for manufacturing the substrate.

### MEANS FOR SOLVING PROBLEM

The present inventors have made a thorough investigation on the problem. As a result, they found that when adopting a structure in which a conductor on a side (lower side) opposite to a side (upper side) where an electronic component is disposed extends in a planar direction, heat generated in the electronic component can be efficiently dissipated, and they have accomplished the invention.

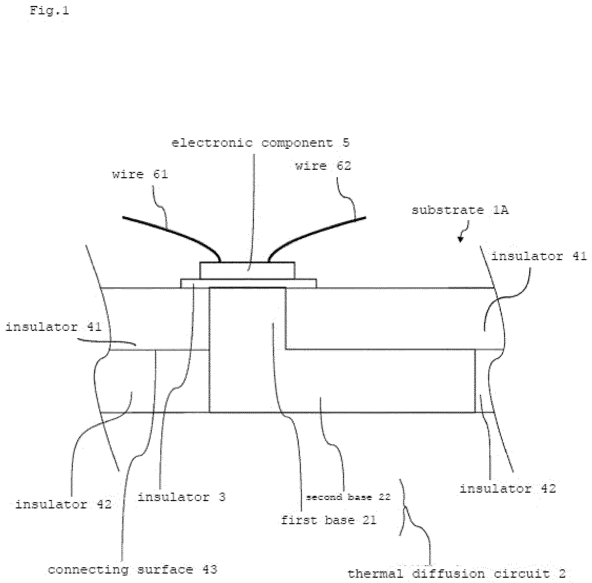

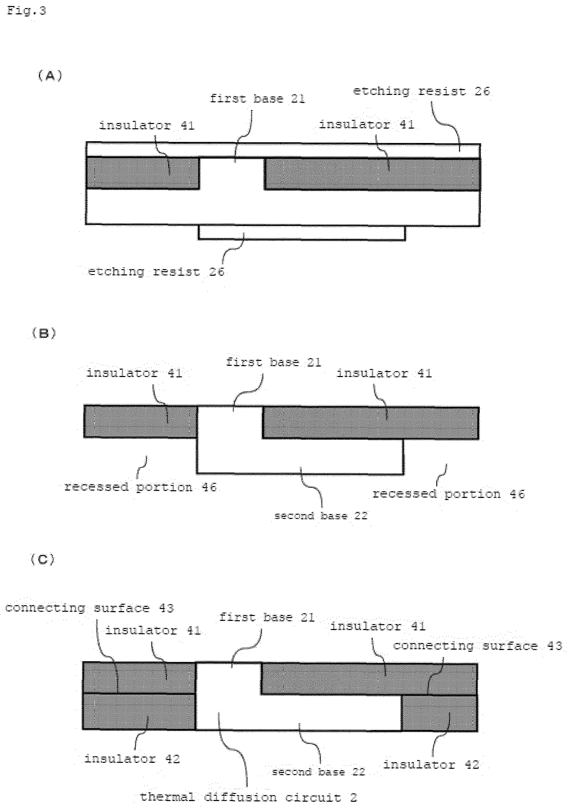

To solve the problem, according to an aspect of the invention, there is provided a substrate (Paragraph [0068] related to Fig. 1 and Fig. 3) including a thermal diffusion circuit 2 configured to cause heat to flow by using a temperature difference and an insulator 3, in which the thermal diffusion circuit 2 includes a first base 21 and a second base 22, the first base 21 and the second base 22 have an integral structure without a connecting surface, the first base 21 is disposed on a side (upper side) where an electronic component 5 is disposed, the second base 22 is disposed on a side (lower side) opposite to the side where the electronic component 5 is disposed, the second base 22 has a structure extending beyond the first base 21 in a planar direction, and the insulator 3 is disposed on a side (upper side) of the first base 21 where the electronic component 5 is disposed.

According to the substrate of the invention, since the second base 22 of the thermal diffusion circuit 2 has a structure extending beyond the first base 21 located on a side (upper side) where the electronic component 5 is disposed in the planar direction of the substrate, there is an effect of dissipating heat to a side opposite to the side where the electronic component 5 is disposed.

In addition, since the insulator 3 is disposed on a side (upper side) where the electronic component 5 is disposed, there is an effect of suppressing electricity from flowing through the thermal diffusion circuit 2 even in a case where the electronic component 5 gets out of order.

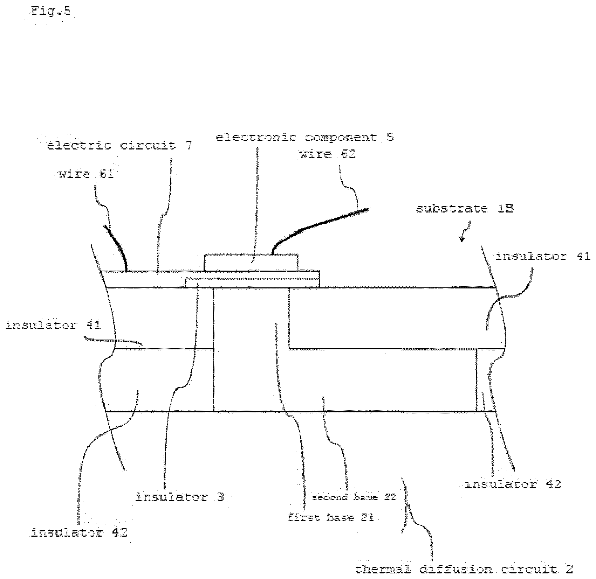

Furthermore, as one embodiment (Fig. 5) of the substrate of the invention, an electric circuit 7 configured to supply electricity to the electronic component 5 is disposed on a side (upper side) of the insulator 3 where the electronic component 5 is disposed in contact with the insulator 3.

According to the substrate, heat generated in the electronic component 5 is transferred to both the thermal diffusion circuit 2 and the electric circuit 7, and thus a heat dissipation effect can be improved.

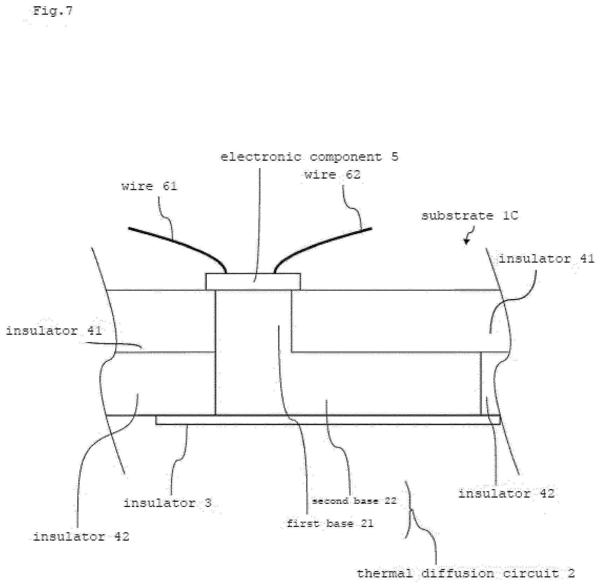

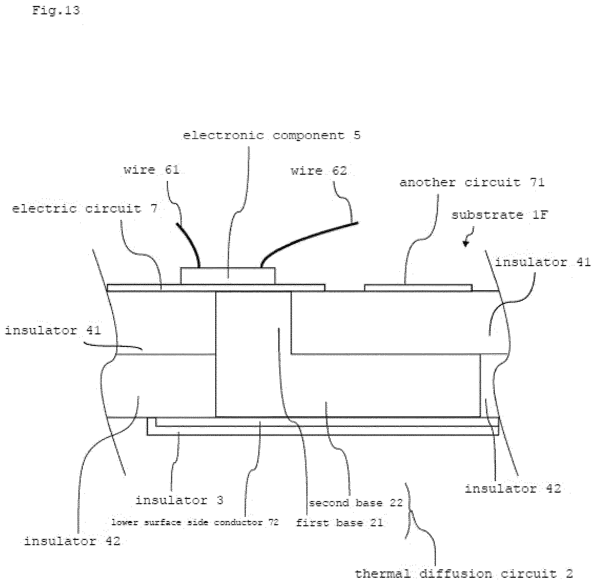

In addition, according to another aspect of the invention, there is provided a substrate (Fig. 7 and Fig. 13) including a thermal diffusion circuit 2 configured to cause heat to flow by using a temperature difference, and an insulator 3, in which the thermal diffusion circuit 2 includes a first base 21 and a second base 22, the first base 21 and the second base 22 have an integral structure without a connecting surface, the first base 21 is disposed on a side (upper side) where an electronic component 5 is disposed, the second base 22 is disposed on a side (lower side) opposite to the side where the electronic component 5 is disposed, the second base 22 has a structure extending beyond the first base 21 in a planar direction, and the insulator 3 is disposed on a side (lower side) of the second base 22 which is opposite to the side where the electronic component 5 is disposed.

According to the substrate, since the second base 22 of the thermal diffusion circuit 2 has a structure extending beyond the first base 21 located on a side (upper side) where the electronic component 5 is disposed in the planar direction of the substrate, there is an effect that heat is efficiently dissipated to a side opposite to the side where the electronic component 5 is disposed.

In addition, since the insulator 3 is disposed to cover the thermal diffusion circuit 2 on a side opposite to the side where the electronic component 5 is disposed, there is an effect of efficiently transferring heat generated in the electronic component 5 by the thermal diffusion circuit 2.

In addition, since the insulator 3 is provided, even in a case where the electronic component 5 gets out of order, it is possible to suppress electricity from flowing to a lower surface side through the thermal diffusion circuit 2.

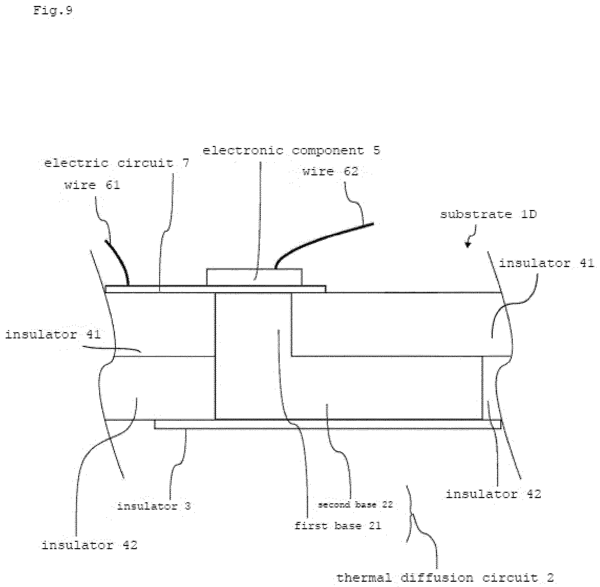

In addition, according to still another aspect of the invention, there is provided a substrate (Fig. 9 and Fig. 13) including a thermal diffusion circuit 2 configured to cause heat to flow by using a temperature difference, an electric circuit 7 configured to supply electricity to an electronic component 5, and an insulator 3, in which the thermal diffusion circuit 2 includes a first base 21 and a second base 22, the first base 21 and the second base 22 have an integral structure without a connecting surface, the first base 21 is disposed on a side (upper side) where the electronic component 5 is disposed, the second base 22 is disposed on a side (lower side) opposite to the side where the electronic component 5 is disposed, the second base 22 has a structure extending beyond the first base 21 in a planar direction, the insulator 3 is disposed on a side (lower side) of the second base 22 which is opposite to the side where the electronic component 5 is disposed, and the electric circuit 7 is disposed on a side (upper side) of the thermal diffusion circuit 2 where the electronic component 5 is disposed.

According to the substrate, since the second base 22 of the thermal diffusion circuit 2 has a structure extending beyond the first base 21 on a side (upper side) where the electronic component 5 is disposed in the planar direction of the substrate, there is an effect of efficiently dissipating heat to a side opposite to the side where the electronic component 5 is disposed.

In addition, since the insulator 3 is disposed to cover the thermal diffusion circuit 2 on a side opposite to the side where the electronic component 5 is disposed, it is possible to suppress electricity from flowing to a rear surface side through the thermal diffusion circuit 2 even in a case where the electronic component 5 gets out of order.

Furthermore, since heat generated in the electronic component 5 is transferred to both the thermal diffusion circuit 2 and the electric circuit 7, the heat dissipation effect can be further improved.

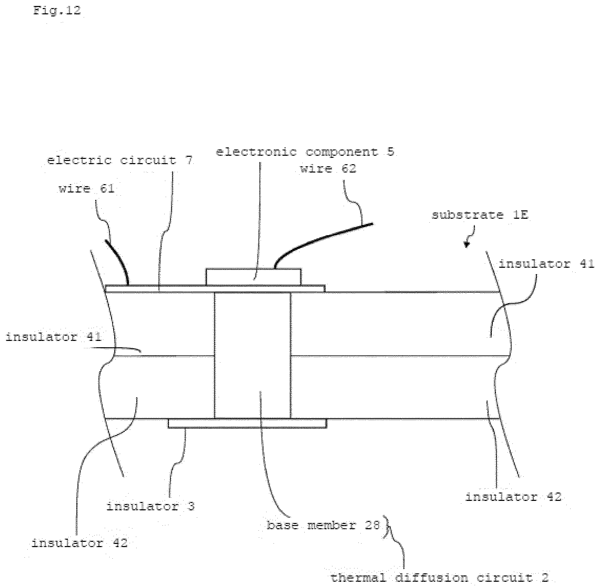

In addition, according to still another aspect of the invention, there is provided a substrate (Fig. 12) including a thermal diffusion circuit 2 configured to cause heat to flow by using a temperature difference, an insulator 3, and an electric circuit 7 configured to supply electricity to an electronic component 5, in which the thermal diffusion circuit 2 is a columnar base member 28, the electric circuit 7 is disposed on one side (upper side) of the base member 28 in a contact state, and the insulator 3 is disposed on the other side (lower side) of the base member 28 in a contact state.

According to the substrate, the electric circuit 7 is disposed on one side of the base member 28 in a contact state, heat generated in the electronic component 5 is transferred to both the thermal diffusion circuit 2 and the electric circuit 7, and thus the heat dissipation effect can be further improved.

In addition, since the insulator 3 is disposed on the other side of the base member 28 in a contact state, it is possible to suppress electricity from flowing to a lower surface side through the base member 28 even in a case where the electronic component 5 gets out of order.

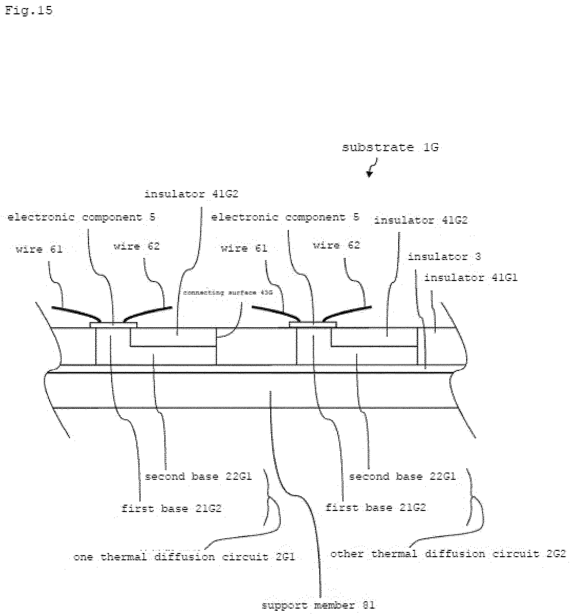

In addition, according to still another aspect of the invention, there is provided a substrate (Fig. 15) including one thermal diffusion circuit 2G1 configured to cause heat to flow by using a temperature difference, the other thermal diffusion circuit 2G2, a support member 81, and an insulator 3, in which the one thermal diffusion circuit 2G1 includes one first base 21G1 and one second base 22G1, the one first base 21G1 and the one second base 22G1 have an integral structure without a connecting surface, the one first base 21G1 is disposed on a side where an electronic component 5 is disposed, the one second base 22G1 is disposed on a side opposite to the side where the electronic component 5 is disposed, the one second base 22G1 has a structure extending beyond the one first base 21G1 in a planar direction, the other thermal diffusion circuit 2G2 includes the other first base 21G2 and the other second base 22G2, the other first base 21G2 and the other second base 22G2 have an integral structure without a connecting surface, the other first base 21G2 is disposed on the side where the electronic component 5 is disposed, the other second base 22G2 is disposed on a side opposite to the side where the electronic component 5 is disposed, the other second base 22G2 has a structure extending beyond the other first base 21G2 in the planar direction, the insulator is disposed on a side of the one second base 22G1 and the other second base 22G2 which is opposite to the side where the electronic component 5 is disposed, and the support member 81 is disposed across the one second base 22G1 and the other second base 22G2 via the insulator 3.

According to the substrate, since the support member 81 is disposed across the one second base and the other second base via the insulator, there is an effect of increasing the rigidity of the substrate in addition to a role of supporting the thermal diffusion circuit 2G1 and the thermal diffusion circuit 2G2.

In addition, the support member 81 has an effect of dissipating heat due to the electronic component 5 which is transferred sequentially through the thermal diffusion circuit 2G1 or the thermal diffusion circuit 2G2, and the insulator 3.

In addition, according to still another aspect of the invention, there is provided an electronic device (Fig. 1 and Fig. 5) including the substrate, and an electronic component 5, in which the insulator 3 is interposed between the first base 21 and the electronic component 5.

According to the electronic device, since the insulator 3 is disposed between the first base 21 and the electronic component 5, it is possible to realize an electronic device capable of suppressing electricity from flowing through the thermal diffusion circuit 2 even in a case where the electronic component 5 gets out of order.

In addition, according to still another aspect of the invention, there is provided an electronic device (Fig. 7, Fig. 9, and Fig. 12) including the substrate, and an electronic component 5, in which an insulator 3 is not provided between the first base 21 and the electronic component 5, or between the base member 28 and the electronic component 5.

According to the electronic device, since the insulator 3 is disposed to cover the thermal diffusion circuit 2 on a side opposite to a side where the electronic component 5 is disposed, it is possible to realize an electronic device capable of efficiently transferring heat generated in the electronic component 5 by the thermal diffusion circuit 2.

### EFFECT OF THE INVENTION

According to the invention, a conductor on a side (lower side) opposite to a side (upper side) where an electronic component is disposed has a structure extending beyond a conductor on the side where the electronic component is disposed in a planar direction, heat generated in the electronic component can be efficiently dissipated.

### BRIEF DESCRIPTION OF DRAWINGS

Fig. 1 is a schematic view illustrating a state in which a substrate of a first embodiment of the invention is cut out in a plate thickness direction;
Fig. 2 is a view illustrating manufacturing processes of the substrate of the first embodiment of the invention;
Fig. 3 is a view illustrating manufacturing processes of the substrate of the first embodiment of the invention;
Fig. 4 is a view illustrating manufacturing processes of the substrate of the first embodiment of the invention;
Fig. 5 is a schematic view illustrating a state in which a substrate of a second embodiment of the invention is cut out in the plate thickness direction;
Fig. 6 is a view illustrating manufacturing processes of the substrate of the second embodiment of the invention;
Fig. 7 is a schematic view illustrating a state in which a substrate of a third embodiment of the invention is cut out in the plate thickness direction;
Fig. 8 is a view illustrating manufacturing processes of the substrate of the third embodiment of the invention;
Fig. 9 is a schematic view illustrating a state in which a substrate of a fourth embodiment of the invention is cut out in the plate thickness direction;
Fig. 10 is a view illustrating manufacturing processes of the substrate of the fourth embodiment of the invention;
Fig. 11 is a view illustrating manufacturing processes of the substrate of the fourth embodiment of the invention;
Fig. 12 is a schematic view illustrating a state in which a substrate of a modification example of the fifth embodiment of the invention is cut out in the plate thickness direction;
Fig. 13 is a schematic view illustrating a state in which a substrate of a sixth embodiment (modification example of the first embodiment to the fourth embodiment) of the invention is cut out in the plate thickness direction;
(A) of Fig. 14 is an enlarged schematic view of a thermal diffusion circuit of a substrate 1A of the first embodiment of the invention, and (B) of Fig. 14 is an enlarged schematic view of a thermal diffusion circuit of a substrate 1A of the fifth embodiment of the invention;
Fig. 15 is a schematic view illustrating a state in which a substrate of a seventh embodiment of the invention is cut out in the plate thickness direction;
Fig. 16 is a schematic view illustrating a state when viewing the substrate of the seventh embodiment from an upper side (side in which an electronic component is mounted) in a state in which the electronic component is not mounted;
Fig. 17 is a view illustrating manufacturing processes of the substrate of the seventh embodiment of the invention;
Fig. 18 is a view illustrating manufacturing processes of the substrate of the seventh embodiment of the invention;
Fig. 19 is a view illustrating manufacturing processes of the substrate of the seventh embodiment of the invention;
Fig. 20 is a perspective view illustrating a state in which an electronic component is mounted on a substrate similar to the sixth embodiment (Fig. 13) of the invention;
Fig. 21 is a view illustrating a partially enlarged state of a cross-section viewed from a direction A-A in Fig. 20; and
Fig. 22 is a schematic view of a state in which a substrate similar to the sixth embodiment (Fig. 13) is cut out in the plate thickness direction.

### BEST MODE(S) FOR CARRYING OUT THE INVENTION

Hereinafter, embodiments of a substrate and a method for manufacturing the substrate according to the invention will be described in detail with reference to the accompanying drawings.

Note that, the substrate and the method for manufacturing the substrate described in the embodiments are merely exemplified to explain the substrate and the method for manufacturing the substrate according to the invention, and the invention is not limited thereto.

The substrate of the invention includes a conductor and an insulator, and the conductor that is a circuit of the substrate (printed circuit) and an electronic component are electrically connected to constitute an electronic device.

The substrate of the invention includes a thermal diffusion circuit including a first base and a second base, or a columnar base member, and has a structure capable of efficiently dissipating heat from the electronic component.

Note that, a rolled conductor in this specification is a conductor manufactured by inserting a conductor ingot that is a raw material between two rotating rolls, and stretching the ingot while pressing the ingot to a desired thickness. Specifically, a rolled copper plate or a rolled aluminum plate corresponds to the rolled conductor. Note that, in the invention, a rolled copper ingot or a rolled aluminum ingot can also be used without limitation to the rolled plate.

In addition, an electrolytic conductor in this specification is not particularly limited as long as the electrolytic conductor is a conductor manufactured by a plating treatment, but specifically, a copper plating treatment can be exemplified.

The rolled conductor has a layered metallographic structure extending in a rolling direction (a planar (X-Y axis of the substrate) direction in a case of using a plate-shaped conductor). In addition, due to a heat treatment in a process of manufacturing the substrate, there are characteristics in which approximately equiaxed crystal grains are obtained.

On the other hand, the electrolytic conductor formed by the plating treatment has a characteristic of a columnar metallographic structure in a thickness direction (Z-axis direction).

The rolled conductor and the electrolytic conductor have a difference in the characteristics. Therefore, due to the difference in the characteristics, the rolled conductor has an effect of further improving rigidity of the substrate as compared with the electrolytic conductor.

### [First Embodiment]

### <Substrate>

A structure of the substrate according to an aspect for carrying out the invention will be described with reference to Fig. 1. Note that, Fig. 1 shows a state of an electronic device in which an electronic component 5 is mounted on a substrate 1A of the invention. The substrate 1A of the invention includes a thermal diffusion circuit 2, an insulator 3, and insulators 41 and 42 (which may be referred to as support insulators for distinguishment from the insulator 3).

The insulators 41 and 42 spread out in the same plane as the thermal diffusion circuit 2, and serve as plate-shaped structures that support the thermal diffusion circuit 2.

Note that, the electronic component 5 is connected to a power supply (not illustrated) by wires 61 and 62, and is in a state in which electricity is supplied so that a function of the electronic component 5 is exhibited.

### <<Thermal Diffusion Circuit>>

The thermal diffusion circuit 2 allows heat to flow by using a temperature difference, and serves to receive heat generated in the electronic component 5 and dissipate the heat to a side (lower side) opposite to a side (upper side) where the electronic component 5 is disposed.

The thermal diffusion circuit 2 includes a first base 21 and a second base 22, and the first base 21 and the second base 22 have an integral structure without a connecting surface in a plate thickness direction and a planar direction. Due to the structure, even though heat is applied to the thermal diffusion circuit 2, or electricity is not supplied to the electronic component 5 and the thermal diffusion circuit 2 is cooled out, and thus thermal expansion is repeated, it is possible to suppress peeling from occurring at the connecting surface.

The first base 21 is an inlet portion where heat generated in the electronic component 5 is received before the second base 22. The first base 21 is located on a side (upper side) where the electronic component 5 is mounted (disposed), and has a structure that does not spread out beyond the second base 22 in the planar direction.

The second base 22 serves to receive the heat of the first base 21 and dissipate the heat to a side (lower side) of the substrate 1A which is opposite to the side where the electronic component 5 is mounted (disposed). The second base 22 is located on a side (lower side) opposite to the side where the electronic component 5 is disposed, and has a structure that spreads out beyond the first base 21 in the planar direction. In addition, a lower surface side of the second base 22 is in a state exposed to a lower surface of the substrate 1A. Note that, an entire periphery of a side surface and an entire upper surface of the second base 22 (a side surface of the first base) are covered with the insulator 41 and the insulator 42, and are not connected to a circuit connected to the power supply so that electricity does not flow therethrough.

The thickness of the first base 21 in the plate thickness direction, and the thickness of the second base 22 in the plate thickness direction are not particularly limited, but it is preferable that the thickness of the second base 22 is larger than the thickness of the first base 21. When the thickness of the second base 22 is increased, a volume of the conductor of the thermal diffusion circuit 2 is increased, more heat emitted from the electronic component 5 can be received, and a heat dissipation effect is improved.

In addition, a material of the thermal diffusion circuit 2 may be a material that transfers heat, and may have thermal conductivity higher than that of the insulators 41 and 42. Specifically, conductors such as copper and aluminum can be exemplified. The thermal diffusion circuit 2 may be formed from either a rolled conductor or an electrolytic conductor obtained by a plating treatment. However, it is more preferable to form the thermal diffusion circuit 2 from the rolled conductor, from the viewpoint of improving the rigidity of the substrate 1A.

Furthermore, it is more preferable to form the thermal diffusion circuit 2 from the rolled conductor and to set the thickness of the second base 22 to be larger than the thickness of the first base 21 from the viewpoints of improving the heat dissipation effect and of further improving the rigidity of the substrate.

Furthermore, when additionally providing a heat dissipation member such as a heat sink on a lower side of the second base 22, it is also possible to further improve the heat dissipation effect.

### <<Insulator>>

The insulator 3 is disposed in contact with an upper-side surface of the thermal diffusion circuit 2 to prevent electricity from flowing to a lower side through the thermal diffusion circuit 2 even when the electronic component 5 gets out of order.

A material of insulator 3 is not particularly limited as long as electricity does not flow to a rear surface side through the thermal diffusion circuit when the electronic component 5 gets out of order, but examples of the material include an insulating resin or an insulating sheet, a ceramic material that is an inorganic material.

The insulator 3 is disposed to cover the entire upper side of the first base 21 across the insulator 41 to be described later, and to extend in the planar direction.

The insulator 3 may be a member that can insulate electricity and has a small thickness, and specifically, it is preferable that the thickness of the insulator 3 is smaller than the thickness of the insulators 41 and 42 to be described later. It is preferable that the thickness of the insulator 3 is small from the viewpoint of improving efficiency of heat dissipation from the thermal diffusion circuit 2.

In a case of using the insulating sheet as the insulator 3, for example, an insulating sheet having a thickness of from 100 µm to 200 µm can be used.

In addition, in a case of using the ceramic material as the insulator 3, a plate-shaped ceramic material may be disposed or a ceramic coating is applicable.

As a processing method in a case of the ceramic coating, manufacturing by a cold spray method, an aerosol deposition method, or the like is exemplified.

Among the processing methods of the ceramic coating, when using the aerosol deposition method, a ceramic thin film can be formed and there is an effect of reducing thermal resistance while securing an insulating property as compared with the other processing methods of the ceramic coating.

Note that, as the thickness of the ceramic thin film, from 0.5 µm to 1 mm is exemplified.

Furthermore, when using the aerosol deposition method, since adhesiveness is higher as compared with a processing method in the related art, this method is particularly preferable when being applied to a substrate including the thermal diffusion circuit 2.

The substrate including the thermal diffusion circuit 2 is used when it is necessary to dissipate heat generated from an electronic component, and the heat is also transferred to the substrate itself. In this case, a substrate in which a conductor and an insulator are made of different materials, warpage may occur in the substrate due to a difference between a coefficient of thermal expansion of the conductor and a coefficient of thermal expansion of the insulator.

As described above, the ceramic thin film manufactured by the aerosol deposition method has high adhesiveness, even in a case where warpage occurs in the substrate, it is possible to reduce a concern of peeling-off, and since the thickness can be made small, the effect of improving heat dissipation efficiency increases.

Note that, the aerosol deposition method is a processing method in which fine particles and an ultrafine particle raw material which are prepared in advance by another method are mixed with a gas to be aerosolized, and the resultant aerosol is sprayed to a substate through a nozzle to form a coat. With regard to the aerosol deposition method, for example, a publication of Japanese Patent No. 3265481 or a publication of Japanese Patent No. 3740523 can be exemplified.

In addition, the insulators (support insulators) 41 and 42 support the thermal diffusion circuit 2 in a plate shape, and are disposed in contact with a side surface (planar direction) of the thermal diffusion circuit 2. In addition, the insulators 41 and 42 also serve to maintain an interval with which electricity does not flow from a circuit (not illustrated) disposed on the same plane as the thermal diffusion circuit 2 to the thermal diffusion circuit 2.

When the insulators 41 and 42 are configured to support the thermal diffusion circuit 2 in a plate shape, a material is not particularly limited, but for example, an insulating resin can be exemplified. In addition, the insulator 3, the insulator 41, and the insulator 42 may be made of the same material or different materials.

In addition, the insulator 41 is disposed at a position of the side surface (periphery) of the first base 21 and is disposed to extend in the planar direction. In addition, the insulator 42 is disposed at a position of the side surface (periphery) of the second base 22, and is disposed to extend in the planar direction.

In addition, in Fig. 1, the insulator 41 and the insulator 42 have a connecting surface 43. The connecting surface 43 is in a state of being disposed at a position at the same thickness as a boundary between the first base 21 and the second base 22 in the plate thickness direction. In other words, the connecting surface 43 is located at the same position as a surface where a surface of the second base 22 on a side (upper side) where the electronic component 5 is disposed and a lower surface of the insulator 41 are in contact with each other.

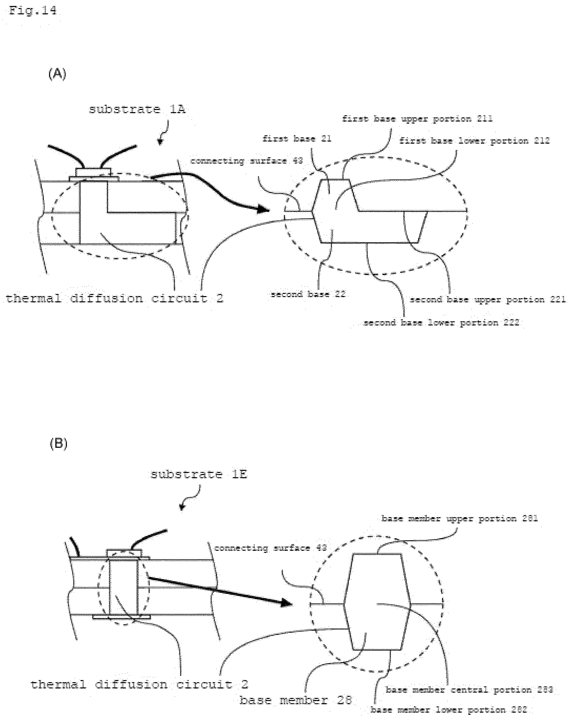

Note that, in a case where the thermal diffusion circuit 2 is provided by etching a rolled conductor shown in a manufacturing method of this embodiment to be described later, as shown in (A) of Fig. 14, a first base lower portion 212 further spreads out in the planar direction and a volume thereof is larger as compared with a first base upper portion 211. In addition, a second base upper portion 221 further spreads out in the planar direction and a volume thereof is larger as compared with a second base lower portion 222.

That is, since the thermal diffusion circuit 2 has a structure in which the central portion in the plate thickness direction spreads out in the planar direction, and a large volume of the conductor can be secured, heat dissipation performance is improved.

### <<Electronic Component>>

The electronic component 5 is not particularly limited as long as heat is generated when electric power is supplied, and is a target component from which the thermal diffusion circuit 2 of the substrate 1A of the invention takes away heat. Specifically, an LED, a power transistor, and the like are exemplified.

### <<Wire>>

Wires 61 and 62 are provided to supply electricity to the electronic component 5. A structure of the wires 61 and 62 is not particularly limited as long as electricity can be supplied to the electronic component 5, but in this embodiment, a case where connection is made by wire bonding is exemplified. The wires 61 and 62 are connected to a power supply (not illustrated) and serve as a path through which electricity from the power supply flows.

### [Method for Manufacturing Substrate]

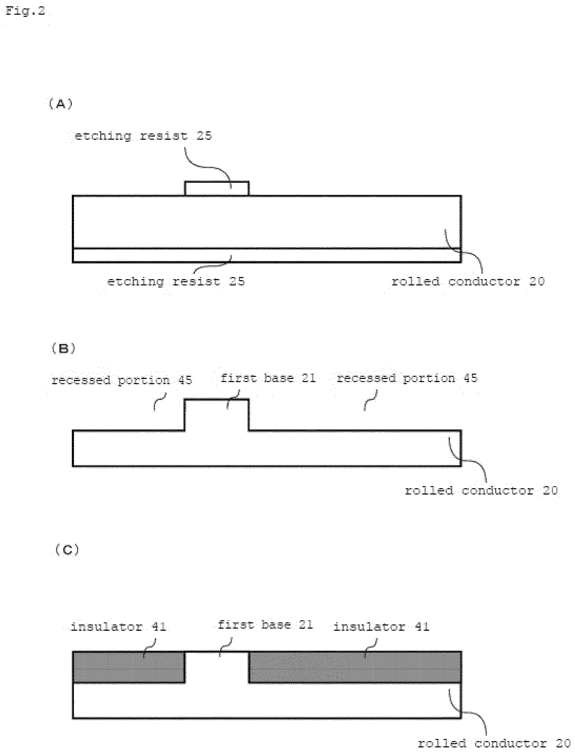

Next, a method for manufacturing the substrate 1A of the invention will be described with reference to Fig. 2 to Fig. 4.

First, a plate-shaped rolled conductor 20 is prepared. This process is referred to as a rolled conductor preparing process.

Next, as shown in Fig. 2(A), an etching resist 25 is provided on a surface of the rolled conductor 20. A process of covering a portion that becomes the first base 21 in a surface the rolled conductor 20 on one side (upper side) with the etching resist 25 is performed. This process is referred to as a first resist forming process.

Note that, in the first resist forming process, the entirety of a surface of the rolled conductor 20 on the other side may also be protected with the etching resist 25.

Next, in a state of being covered with the etching resist 25 in the first resist forming process, the rolled conductor 20 is etched (half-etched). This process is referred to as a first etching process. According to this process, a recessed portion 45 is formed in the surface of the rolled conductor 20 on one side, and thus the first base 21 is formed. Then, the etching resist 25 provided in the first resist process is removed, and enters a state shown in Fig. 2(B). Note that, a surface of the recessed portion 45 on a lower side becomes the connecting surface 43.

Next, as shown in Fig. 2(C), a process of filling the recessed portion 45 on one side with an insulating resin is performed. This process is referred to as a first insulating resin filling process.

According to this process, the insulator 41 that is a support insulator is formed.

Note that, after the first insulating resin filling process, the surface on one side may be subjected to a scrubbing treatment so that the surfaces of the insulator 41 (insulating resin) and the first base 21 become flat surfaces. This process is referred to as first scrubbing process.

As shown in Fig. 3(A), a process of covering a portion that becomes the second base 22 in a surface of the rolled conductor 20 on the other side (lower side) with an etching resist 26 is performed. This process is referred to as a second resist forming process.

Note that, in the second resist forming process, the entirety of the surface of the rolled conductor 20 on one side may be protected with the etching resist 26.

Next, in a state of being covered with the etching resist 26 in the second resist forming process, the rolled conductor 20 is etched. This process is referred to as a second etching process. According to this process, a recessed portion 46 is formed in the surface of the rolled conductor 20 on the other side. Then, the etching resist provided in the second resist process is removed, and enters a state shown in Fig. 3(B). Note that, with regard to the recessed portion 46, etching is performed so that a rear surface (lower side) of the insulator 41 enters an exposed state. In addition, according to this process, the second base 22 is formed, and the thermal diffusion circuit 2 is completed.

Next, as shown in Fig. 3(C), a process of filling the recessed portion 46 on the other side with an insulating resin is performed. This process is referred to as a second insulating resin filling process. According to this process, the insulator 42 that is a support insulator is formed. In addition, the connecting surface 43 is completed by this process.

Note that, after the second insulating resin filling process, the surface on the other side may be subjected to the scrubbing treatment so that the surfaces of the insulator 42 (insulating resin) and the second base 22 become flat surfaces. This process is referred to as a second scrubbing process.

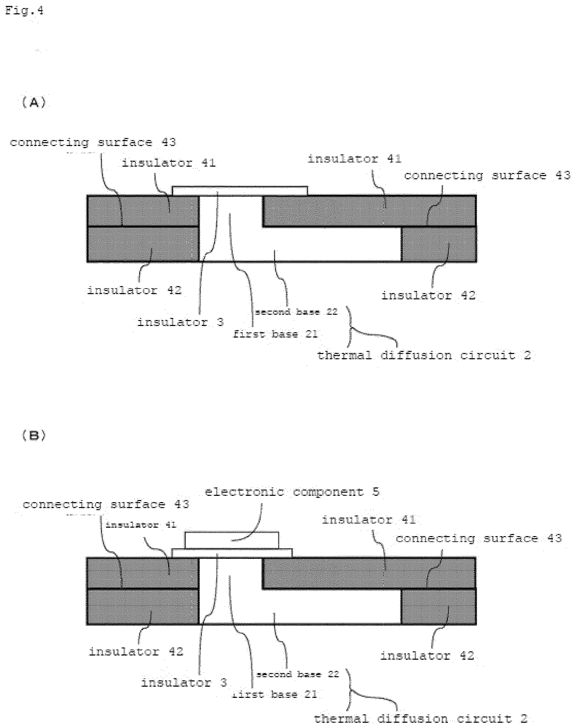

Next, as shown in Fig. 4(A), an insulating sheet or a ceramic material is disposed to cover the entirety of the upper side of the first base 21, and the insulator 3 is formed. This process is referred to as an insulator upper surface installation process. When the insulator 3 is formed, the substrate 1A is completed.

Then, a solder resist is provided on the upper-side surface and the lower-side surface of the substrate 1A to protect the substrate surfaces, or a heat dissipation member such as a heat sink is provided on the lower side of the second base 22 to further improve heat dissipation efficiency of the substrate. Then, as shown in Fig. 4(B), the electronic component 5 is disposed on the insulator 3, and the wires 61 and 62 are provided by wire bonding, thereby obtaining the electronic device shown in Fig. 1. Electricity flows between the wire 61, the electronic component 5, and the wire 62 from the power supply (not illustrated). In addition, heat generated in the electronic component 5 is dissipated to the lower surface side of the substrate 1A through the insulator 3, the first base 21, and the second base 22.

### [Second Embodiment]

### <Substrate>

A structure of a substrate according to a second embodiment for carrying out the invention will be described with reference to Fig. 5. Note that, the same reference numeral will be given to a portion having the same structure as in the substrate 1A of the first embodiment, and description thereof will be omitted. A substrate 1B of the invention is different from the substrate 1A of the first embodiment in that an electric circuit 7 is provided.

### <<Electric Circuit>>

The electric circuit 7 is a circuit configured to supply electricity to the electronic component 5, and also has a function of cooling out the electronic component 5 in combination with the thermal diffusion circuit 2 by receiving a part of heat emitted from the electronic component 5.

The electric circuit 7 is provided on a surface of the substrate 1B on a side where the electronic component 5 is provided to extend in the planar direction. The electric circuit 7 is disposed to be located immediately below the electronic component 5, and is disposed to cover an upper side of the insulator 3.

The electric circuit 7 is not particularly limited as long as electric is allowed to flow, but it is preferable to form the electric circuit 7 with an electrolytic conductor from the viewpoint that manufacturing is simple.

Since the electric circuit 7 is disposed between the insulator 3 and the electronic component 5, the electric circuit 7 enters a state of being disposed in contact with the insulator 3 on a side (upper side) of the insulator 3 where the electronic component 5 is disposed.

In addition, the electric circuit 7 is disposed in contact with the electronic component 5, and is connected to the electronic component 5 with a connection member such as a solder to supply electricity.

### [Method for Manufacturing Substrate]

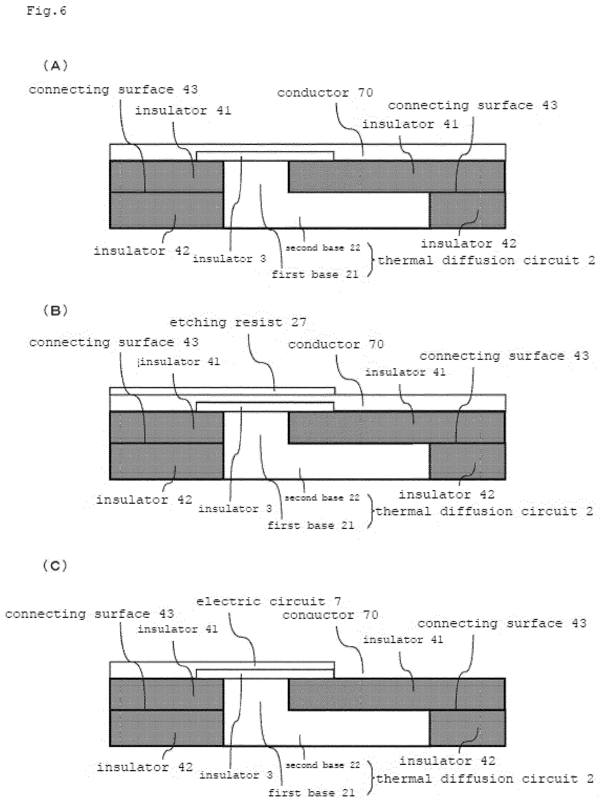

A method for manufacturing the substrate 1B will be described with reference to Fig. 6. The method for manufacturing the substrate 1B is the same as the method for manufacturing the substrate 1A of the first embodiment of the invention, and thus from the rolled conductor preparing process to the insulator upper surface installation process are performed.

In a state shown in Fig. 4(A), a conductor 70 is provided on the entirety of a surface on a side (upper side) where the electronic component 5 is disposed as shown in Fig. 6(A). More specifically, an electrolytic conductor is provided by a plating treatment. This process is referred to as a conductor forming process.

Next, as shown in Fig. 6(B), an etching resist 27 is provided on a surface of the conductor 70 to cover a site that becomes the electric circuit 7. This process is referred to as a third resist forming process.

Next, in a state in which the etching resist 27 is provided, the electric circuit 7 is formed by etching treatment. This process is referred to as an electric circuit forming process. The substrate 1B is completed by this process. Then, the etching resist 27 is removed, and the substrate 1B shown in Fig. 6(C) is obtained.

Note that, in the third resist forming process, the entirety of the surface of the thermal diffusion circuit 2 on a lower side may be protected by the etching resist 27.

Then, as in the substrate 1A, a solder resist is provided in the substrate 1B, or a heat dissipation member is provided on the lower side of the second base 22. Then, as shown in Fig. 5, the electronic component 5 is disposed on the electric circuit 7, the wire 61 such as wire bonding is connected to the electric circuit 7, and the wire 62 is connected to the electronic component 5. Electricity supplied from the power supply (not illustrated) flows between the wire 61, the electric circuit 7, the electronic component 5, and the wire 62. In addition, heat generated in the electronic component 5 is dissipated to a lower surface side of the substrate 1B sequentially through the electric circuit 7, the insulator 3, the first base 21, and the second base 22. In addition, a part of the heat is transferred in the planar direction of the electric circuit 7, and is dissipated to an upper surface side of the substrate 1B.

### [Third Embodiment]

### <Substrate>

A structure of a substrate according to a third embodiment for carrying out the invention will be described with reference to Fig. 7. Note that, the same reference numeral will be given to a portion having the same structure as in the substrate 1A of the first embodiment, and description thereof will be omitted. A substrate 1C of the invention is different from the substrate 1A of the first embodiment in that the insulator 3 is disposed at a different site, and the insulator 3 is not provided between the first base 21 and the electronic component 5.

### <<Insulator>>

The insulator 3 is disposed for insulation so that electricity does not flow to a lower surface side of the substrate 1C through a thermal diffusion circuit when the electronic component 5 is damaged.

The insulator 3 is disposed to be in contact with the second base 22 and to cover the entirety of a surface (lower surface) on a side opposite to a side where the electronic component 5 is disposed.

### <<Electronic Component>>

The electronic component 5 is disposed in contact with the first base 21 of the thermal diffusion circuit 2. Accordingly, the substrate 1C can receive heat from the electronic component 5 more quickly as compared with a case where the substrate 1A in which the insulator 3 is disposed between the electronic component 5 and the first base 21, and thus the heat dissipation effect is improved.

### [Method for Manufacturing Substrate]

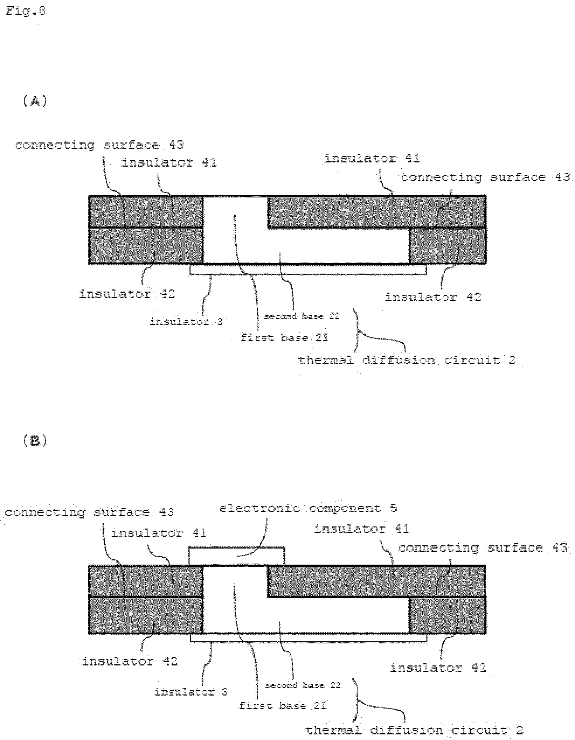

A method for manufacturing the substrate 1C will be described with reference to Fig. 8. The method for manufacturing the substrate 1C is the same as the method for manufacturing the substrate 1A of the first embodiment of the invention, and thus from the rolled conductor preparing process to the second insulating resin filling process are performed.

In a state shown in Fig. 3(C), an insulating sheet or a ceramic coating is disposed to cover the entirety of the lower surface of the second base 22, and the insulator 3 is formed as shown in Fig. 8(A). This process is referred to as an insulator lower surface installation process. When the insulator 3 is formed, the substrate 1C is completed.

Then, as in the substrate 1A, a solder resist is provided on the substrate 1C, or a heat dissipation member is provided in the insulator 3 disposed on a lower side of the second base 22. Then, as shown in (B) of Fig. 8, the electronic component 5 is disposed on the first base 21, the wires 61 and 62 are provided by wire bonding, thereby obtaining an electronic device shown in Fig. 7. Electricity supplied from the power supply (not illustrated) flows between the wire 61, the electronic component 5, and the wire 62. In addition, heat generated in the electronic component 5 is dissipated to a rear surface side of the substrate 1C sequentially through the first base 21, the second base 22, and the insulator 3.

### [Fourth Embodiment]

### <Substrate>

A structure of a substrate according to a fourth embodiment for carrying out the invention will be described with reference to Fig. 9. Note that, the same reference numeral will be given to a portion having the same structure as in the substrate 1B of the second embodiment, and description thereof will be omitted. A substrate 1D of the invention is different from the substrate 1B of the second embodiment in a site where the insulator 3 is disposed, and in that the insulator 3 is not provided between the first base 21 and the electric circuit 7, and the first base 21 and the electric circuit 7 are disposed in a contact state.

### <<Insulator>>

The insulator 3 is similar to the third embodiment, and is disposed for insulation so that electricity does not flow to a lower surface side of the substrate 1D through the thermal diffusion circuit 2 when the electronic component 5 is damaged.

The insulator 3 is disposed to be in contact with the second base 22 and to cover the entirety of a surface (lower surface) on a side opposite to a side where the electronic component 5 is disposed.

### <<Electronic component>>

The electronic component 5 is disposed in contact with the electric circuit 7. Accordingly, the substate 1D can receive heat from the electronic component 5 more quickly, and the heat dissipation effect is further improved as compared with the substrate 1A or the substrate 1B in a case where the insulator 3 is disposed between the electronic component 5 and the first base 21. In addition, heat spreads out in a planar direction of the electric circuit 7, and thus the heat dissipation effect increases as compared with the substrate 1C.

Note that, in this embodiment, when electricity is supplied to the electronic component 5, electric charges are applied to the thermal diffusion circuit 2, but in order to prevent electricity from flowing to other portions through the thermal diffusion circuit 2, the insulator 3 is disposed on a lower side of the thermal diffusion circuit 2, and the insulators 41 and 42 are disposed on an entire periphery of a side surface of the thermal diffusion circuit 2 and an entire upper surface of the second base 22. The thermal diffusion circuit 2 is a conductor structure that is not used as a path through which electricity flows although applied with the electric charges, and in the substrate 1D, the conductor structure is provided in the circuit.

### [Method for Manufacturing Substrate]

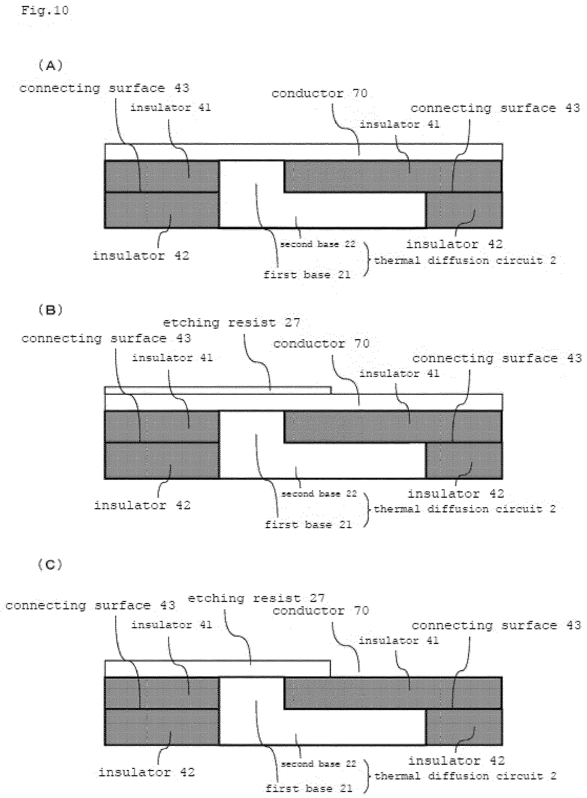

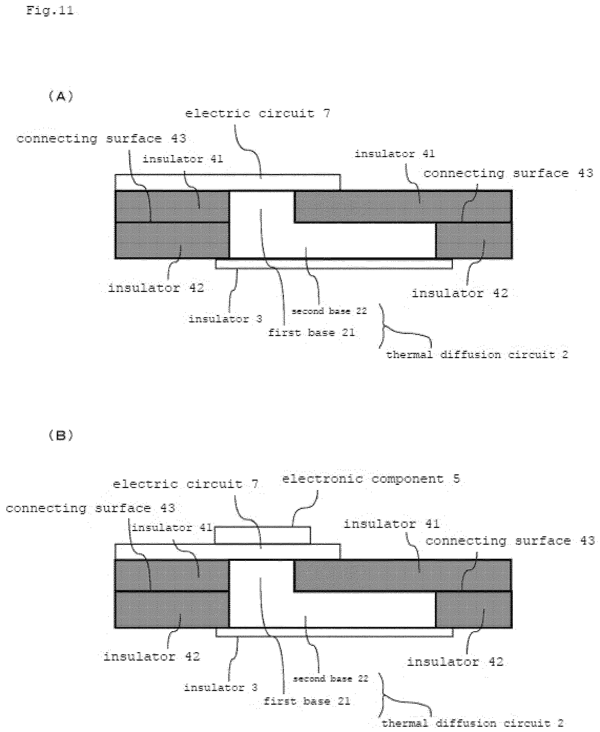

A method for manufacturing the substrate 1D will be described with reference to Fig. 10. In the method for manufacturing the substrate 1D, from the rolled conductor preparing process to the second insulating resin filling process in the method for manufacturing the substrate 1A are performed ((C) of Fig. 3). Then, as in the method for manufacturing the substrate 1B, the conductor forming process ((A) of Fig. 10), the third resist forming process ((B) of Fig. 10), and the electric circuit forming process ((C) of Fig. 10) are performed. Then, as in the method for manufacturing the substrate 1C, the insulator lower surface installation process ((A) of Fig. 11) is performed.

Note that, in the conductor forming process ((A) of Fig. 10), the conductor 70 is formed across the surfaces of the insulator 41 and the first base 21.

Then, as in the substrates 1A to 1C, a solder resist is provided on the substrate 1D, or a heat dissipation member is provided in the insulator 3 disposed on a lower side of the second base 22. Then, as shown in (B) of Fig. 11, the electronic component 5 is disposed on the electric circuit 7, the wire 61 such as wire bonding is connected to the electric circuit 7, and the wire 62 is connected to the electronic component 5, thereby obtaining an electronic device shown in Fig. 9. Electricity supplied from the power supply (not illustrated) flows between the wire 61, the electric circuit 7, the electronic component 5, and the wire 62. In addition, heat generated in the electronic component 5 is dissipated to a rear surface side of the substrate 1D sequentially through the electric circuit 7, the first base 21, the second base 22, and the insulator 3. In addition, a part of the heat is transferred in the planar direction of the electric circuit 7, and is dissipated to an upper surface side of the substrate 1D.

### [Fifth Embodiment]

### <Substrate>

A structure of a substrate according to a fifth embodiment for carrying out the invention will be described with reference to Fig. 12. Note that, the same reference number will be given to a portion having the same structure as in the substrate 1D of the fourth embodiment, and description thereof will be omitted. A substrate 1E of the invention is different from the substrate 1D of the fourth embodiment in the shape of the thermal diffusion circuit 2. In addition, the insulator 3 is not provided between the thermal diffusion circuit 2 (base member 28) and the electronic component 5.

### <<Thermal Diffusion Circuit>>

The thermal diffusion circuit 2 includes the base member 28. The base member 28 is a columnar member.

Differently from the first embodiment to the fourth embodiment of the invention, the base member 28 does not have a step between the upper-side portion (corresponding to the first base 21) and the lower-side portion (corresponding to the second base 22) of the thermal diffusion circuit 2.

An area of a surface that is an upper-side surface of the base member 28 and an area of a surface that is a lower-side surface of the base member 28 are the same as each other, or the area of the lower-side surface of the base member 28 is larger than the area of the upper-side surface of the base member 28.

That is, the base member 28 may be formed by inserting a cylindrical conductive member (corresponding to the inlay in the related art) having the same diameter as that of a through-hole provided in a plate thickness direction of the substrate 1E or a truncated conical conductive member in which an area of the upper-side surface is smaller than the area of the lower-side surface into the through-hole up and down, by disposing an integral conductor without a connecting surface by performing a plating treatment on the through-hole, or by providing a rolled conductor without a connecting surface by etching the rolled conductor into an integral columnar shape.

However, in a case where the base member 28 is provided by etching the rolled conductor by a method for manufacturing a substrate shown in a manufacturing method of this embodiment to be described later, as shown in (B) of Fig. 14, since it is possible to obtain a columnar shape in which a base member central portion 283 that is a central portion of the substrate 1E in the plate thickness direction is wider than an upper-side surface of the base member upper portion 281 and a lower-side surface of a base member lower portion 282 in the planar direction, and a volume of the conductor can be increased, this case is preferable from the viewpoint of an effect of dissipating heat generated in the electronic component 5. Note that, the base member upper portion 281 and the base member lower portion 282 may have the same volume or different volumes.

### [Method for Manufacturing Substrate]

A method for manufacturing the substrate 1E will be described. The method for manufacturing the substrate 1E is the same as the method for manufacturing the substrate 1D, and is realized by performing the rolled conductor preparing process to the insulator lower surface installation process.

At this time, the etching resist 25 and the etching resist 26 which are installed in the first resist forming process and the second resist forming process are provided to be a columnar shape after the second etching process.

Then, as in the substrate 1D, a solder resist is provided or a heat dissipation member is provided in the insulator 3 disposed on a lower side of the second base 22. Then, the electronic component 5 is disposed on the electric circuit 7, the wire 61 is connected to the electric circuit 7 by wire bonding, and the wire 62 is connected to the electronic component 5, thereby obtaining an electronic device shown in Fig. 12. Electricity supplied from the power supply (not illustrated) flows between wire 61, the electric circuit 7, the electronic component 5, and the wire 62. In addition, heat generated in the electronic component 5 is dissipated to a rear surface side of the substrate 1E sequentially through the electric circuit 7, the base member 28, and the insulator 3. In addition, a part of the heat is transferred in the planar direction of the electric circuit 7, and is dissipated to a surface side of the substrate 1E.

### [Sixth Embodiment]

In the sixth embodiment of the invention, modification examples of the first embodiment to the fourth embodiment are exemplified. In the first embodiment and the fourth embodiment, as illustrated in Fig. 13, another circuit 71 may be provided in the same layer as in the electric circuit 7 and the electronic component 5. The other circuit 71 is disposed on the upper surface side of the second base 22, and is disposed in a state in which the insulator 41 is interposed therebetween.

In the first embodiment to the fourth embodiment of the invention, since the other circuit 71 can be disposed on the upper side of the second base 22, an effect of improving the degree of freedom of circuit design can also be obtained.

Note that, for example, as in the second embodiment of the invention, the other circuit 71 can be realized by performing the conductor forming process, forming an etching resist that covers a portion that will be the other circuit 71 in the third resist forming process, and performing the electric circuit forming process.

In addition, as illustrated in Fig. 13, a lower surface side conductor 72 may be provided between the second base 22 and the insulator 3 (lower surface side of the second base 22) in the plate thickness direction (on a lower surface side of the second base 22). In other words, the insulator 3 is disposed on the lower side of the second base 22.

Note that, a method for manufacturing the lower surface side conductor 72 can be realized by forming a conductor 70 also on a lower surface side of a substrate in the conductor forming process, forming an etching resist that covers the portion that will be the lower surface side conductor 72 in the third resist forming process, and etching lower-side surface of the substrate in the electric circuit forming process.

In addition, it is preferable that the lower surface side conductor 72 further spreads out in the planar direction as compared with the second base 22, and has an area larger than that of the second base 22. In this case, the effect of dissipating heat from the second base 22 to the outside is further improved.

In the first embodiment to the fourth embodiment of the invention, it is preferable that the electronic component 5, the insulator 3, and the thermal diffusion circuit 2 are arranged in a straight line in the plate thickness direction. That is, a state in which the entirety of a bottom surface (surface on a side where the thermal diffusion circuit 2 is disposed) of the electronic component 5 is mounted above the first base 21 of the thermal diffusion circuit 2 via the insulator 3, or a state in which the entirety of the bottom surface is mounted on the first base 21 of the thermal diffusion circuit 2 in a contact state is preferable from the viewpoint that thermal conduction is efficiently performed.

However, as shown in Fig. 13, even when the electronic component 5 is disposed in a state in which a position thereof is shifted with respect to the first base 21 in the planar direction, or the area of the first base 21 in the planar direction is smaller than the area of the bottom surface of the electronic component 5, the effect of the invention is exhibited.

In addition, in the second embodiment to the fourth embodiment of the invention, a case where the wire 61 is connected to the electric circuit 7 is exemplified, but as in the sixth embodiment, the wire 61 may be connected to the electronic component 5 in Fig. 5 (the second embodiment of the invention) and Fig. 9 (the fourth embodiment). In other words, the electronic device may be in a state in which electricity does not flow to the electric circuit 7. In this case, the electric circuit 7 does not function as a path through which electricity flows, but serves as a circuit for dissipating heat to an upper-side surface.

The insulator 3 may be provided between the electronic component 5 and the electric circuit 7 in the plate thickness direction in substitution for the insulator 3 provided on a lower side of the lower surface side conductor 72. In other words, the insulator 3 may be provided on the upper side (side where the electronic component is disposed) of the first base 21.

Note that, in a case of using a transistor as the electronic component 5, the electric circuit 7 may be used as a circuit (corresponding to a circuit through which both a current and heat flow) through which electricity flow. In this case, for example, design may be made so that the wire 61 functions as a source, the wire 62 functions as a gate, and the electric circuit 7 functions as a drain).

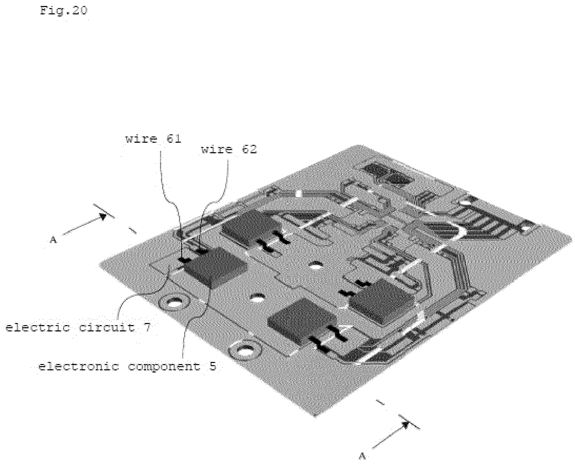

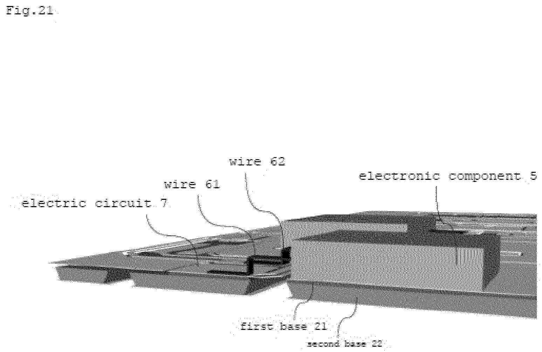

Note that, Fig. 20 is a perspective view illustrating a state in which the electronic component 5 is mounted on a substrate similar to the substrate shown in Fig. 13. In addition, Fig. 21 is a view illustrating a partially enlarged state of a cross-section viewed from a direction A-A in Fig. 20 in a state in which an insulator of the substrate similar to the substrate shown in Fig. 13 is removed.

A difference from the embodiment in Fig. 13 is in that the thermal diffusion circuit 2 has a structure designed so that a large current flows. The large current is a current for allowing the electronic component to operate. A conductor that is used to transmit a logic signal called a signal line from one end to the other end of the circuit, and a conductor functioning as a circuit for supplying electric power to the electronic component are present in the circuit of the substrate. In Fig. 20, a case where the thermal diffusion circuit 2 is used as a circuit configured to supply electric power to the electronic component is exemplified.

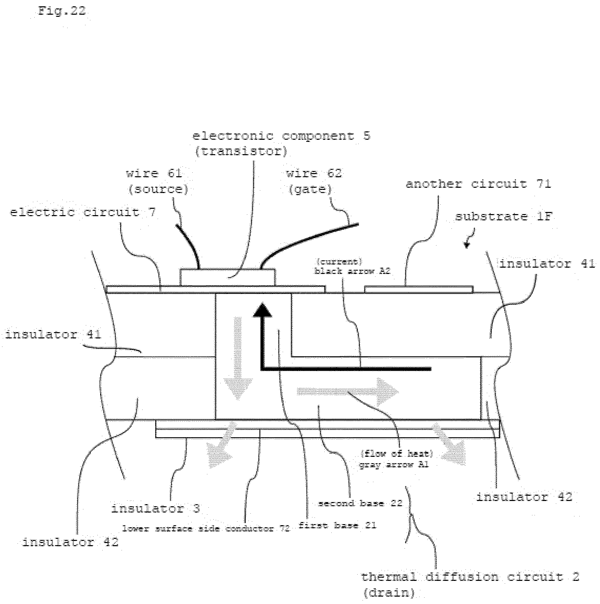

Fig. 22 illustrates a state in which in Fig. 20 and Fig. 21, a transistor is mounted as the electronic component 5, and the second base 2 and another circuit (circuit connected to the power supply) are connected at a site (not illustrated) so that a large current flows through the first base 21 and the second base 22.

The transistor as the electronic component 5 is designed so that the wire 61 functions as a source, the wire 62 functions as a gate, and the thermal diffusion circuit 2 functions as a drain.

When the transistor that is the electronic component 5 operates, electricity is supplied to the electronic component 5 through the thermal diffusion circuit 2, and heat is generated in the transistor. The heat is dissipated to a downward side of the second base through the thermal diffusion circuit 2. In addition, even when electricity is not supplied to the electronic component 5 through the thermal diffusion circuit 2 and the transistor does not operate, the thermal diffusion circuit 2 functions to diffuse residual heat from the transistor.

Note that, this embodiment is also applicable to the fifth embodiment.

In addition, a case where the thermal diffusion circuit 2 dissipates heat emitted from the transistor has been exemplified. However, in a case where the thermal diffusion circuit 2 is designed as a circuit through which a large current flows, the thermal diffusion circuit 2 also serves to dissipate heat generated due to resistance of the conductor when the large current flows therethrough.

In addition, in a case where the thermal diffusion circuit 2 is designed so that a current flows therethrough, the thermal diffusion circuit 2 serves as a circuit through which a current flows, and serves to dissipate heat from the electronic component 5. In this specification, such a circuit is referred to as a circuit through which both a current and heat flow. In Fig. 22, an arrow (gray) A1 indicates a flow of heat, and an arrow (black) A2 indicates a current. Note that, the arrow A2 that is a direction of the current may be reversed.

### [Seventh Embodiment]

### <Substrate>

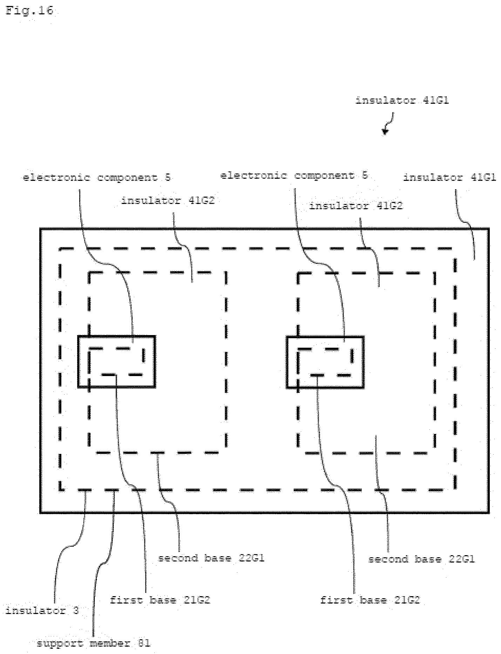

A structure of a substrate according to a seventh embodiment for carrying out the invention will be described with reference to Fig. 15 and Fig. 16. Note that, the same reference numeral will be given to a portion having the same structure as in the substrate 1C of the third embodiment, and description thereof will be omitted. A substrate 1G of the invention is provided with a plurality of thermal diffusion circuits (2G1 and 2G2), the thermal diffusion circuits are provided with a support member 81 having heat dissipation performance higher than that of the insulator 3 via the insulator 3, and the support member 81 is provided across the plurality of thermal diffusion circuits.

### <Thermal Diffusion Circuit>

The thermal diffusion circuit 2G1 includes a first base 21G1 and a second base 22G1. The thermal diffusion circuit 2G1 is formed so that a lower side (side in contact with the insulator 3) of the second base 22G1 has the widest width in the planar (right and left) direction, and a width of an upper side (side where the electronic component 5 is disposed) of the second base 22G1, a width of a lower side of the first base 21G1, and a width of an upper side of the first base 21G1 are gradually narrowed in this order in the planar direction.

The thermal diffusion circuit 2G2 includes a first base 21G2 and a second base 22G2. The thermal diffusion circuit 2G2 is formed so that a lower side (side in contact with the insulator 3) of the second base 22G2 has the widest width in the planar (right and left) direction, and a width of an upper side (side where the electronic component 5 is disposed) of the second base 22G2, a width of a lower side of the first base 21G2, and a width of an upper side of the first base 21G2 are gradually narrowed in this order in the planar direction.

Formation of the thermal diffusion circuit 2G1 and the thermal diffusion circuit 2G2 is realized by an etching treatment to be described later.

The other structures of the thermal diffusion circuit 2G1 and the thermal diffusion circuit 2G2 are similar to those of the thermal diffusion circuit 2 of the first embodiment.

### <<Insulator>>

An insulator 41G1 is disposed to be in contact with an upper surface of the insulator 3, a side surface of the second base 22G1, and a side surface of the second base 22G2, and an upper surface of the insulator 41G1 is located at the same height as an upper surface of the first base 21G1 and an upper surface of the first base 21G2.

In addition, an insulator 41G2 is disposed to be in contact with a side surface of the insulator 41G1, a side surface of the first base 21G1, and an upper surface of the second base 22G1, and is disposed to be contact with a side surface of the insulator 41G1, a side surface of the first base 21G2, and an upper surface of the second base 22G2.

In addition, the insulator 41G1 and the insulator 41G2 have a connecting surface 43G in the plate thickness direction (vertical direction), and does not have a connecting surface in the planar direction. The insulator 41G1 and the insulator 41G2 are support insulators, and a material thereof is similar to that of the support insulator (insulator 41 or 42) of the thermal diffusion circuit 2 of the first embodiment.

### <<Support Member>>

The support member 81 serves to maintain the thermal diffusion circuit 2G1 and the thermal diffusion circuit 2G2, and raises rigidity of the substrate. In addition, the support member 81 serves to dissipate heat that is generated in the electronic component 5 and is transferred sequentially through the thermal diffusion circuit 2G1 or the thermal diffusion circuit 2G2, and the insulator 3. The support member 81 is disposed on a lower side of the insulator 3, and is disposed across the second base 22G1 and the second base 22G2 via the insulator 3. Due to this structure, there is an effect of uniformly dissipating heat while obtaining rigidity by supporting the thermal diffusion circuit 2G1 and the thermal diffusion circuit 2G2.

In addition, the support member 81 may be a material having a heat dissipation performance higher than that of the insulator 3, and specific examples thereof include copper and aluminum.

The support member 81 may be an electrolytic conductor formed by a copper plating treatment, or rolled copper. However, in a case of the electrolytic conductor formed by the copper plating treatment, the electrolytic conductor can be made thin in the plate thickness direction, and has an effect of realizing a reduction in weight of the substrate 1G while having a heat dissipation property. In addition, in a case of the rolled conductor (rolled copper), the rigidity of the substrate 1G can be further raised.

### [Method for Manufacturing Substrate]

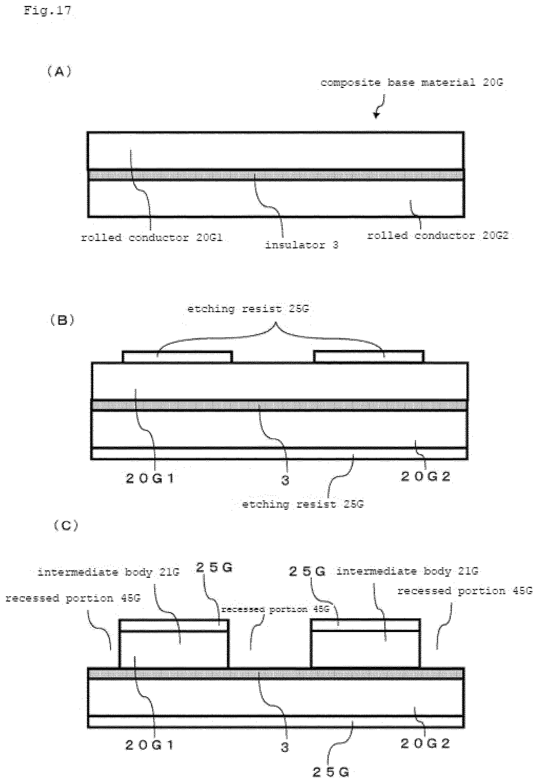

Next, a method for manufacturing the substrate 1G will be described with reference to Fig. 17 to Fig. 19.

First, as shown in Fig. 17(A), a composite base material 20G in which a rolled conductor (copper) 20G1 is bonded to an upper side of the insulator 3 and a rolled conductor (copper) 20G2 is bonded to a lower side of the insulator 3 is prepared. This process is referred to as a composite base material preparing process.

Next, as shown in Fig. 17(B), an etching resist 25G is provided on a surface of the rolled conductor 20G1. A process of covering portions which will be the first base 21G1 and the second base 22G1, and the first base 21G2 and the second base 22G2 in an upper-side surface of the rolled conductor 20G1 with the etching resist 25G is performed. This process is referred to as a first intermediate body resist forming process.

Note that, in the first intermediate body resist forming process, the entirety of a surface on a lower side of the rolled conductor 20G2 may be protected by the etching resist 25G.

Next, in a state of being covered with the etching resist 25G in the first intermediate body resist forming process, the rolled conductor 20G1 is etched. This process is referred to as an intermediate body etching process. Etching is performed until the insulator 3 is exposed as shown in Fig. 17(C). Due to this process, a recessed portion 45G is formed in one surface of the rolled conductor 20G1, and an intermediate body 21G is formed. Then, the etching resist 25G provided in the first intermediate body resist process is removed.

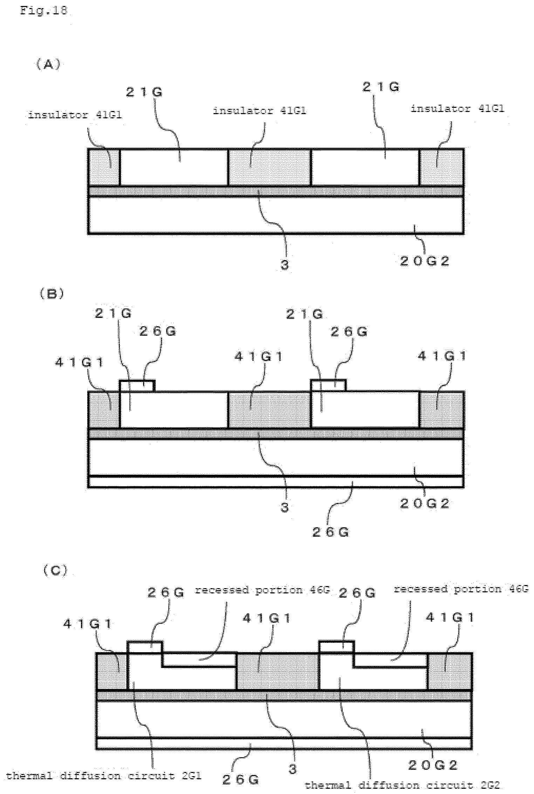

Next, as illustrated in Fig. 18(A), a process of filling the recessed portion 45G with an insulating resin is performed. This process is referred to as a first intermediate body insulating resin filling process.

Due to this process, the insulator 41G1 is formed.

Note that, after the first intermediate body insulating resin filling process, upper-side surfaces may be subjected to a scrubbing treatment so that surfaces of the insulator 41G1 (insulating resin) and the intermediate body 21G become flat surfaces. This process is referred to as a fourth scrubbing process.

As shown in Fig. 18(B), a process of covering portions which will be the first base 21G1 and the first base 21G2 in an upper-side surface of the intermediate body 21G with an etching resist 26G is performed. This process is referred to as a second intermediate body resist forming process.

Note that, in the second intermediate body resist forming process, the entirety of a lower-side surface of the rolled conductor 20G2 is protected by the etching resist 26G.

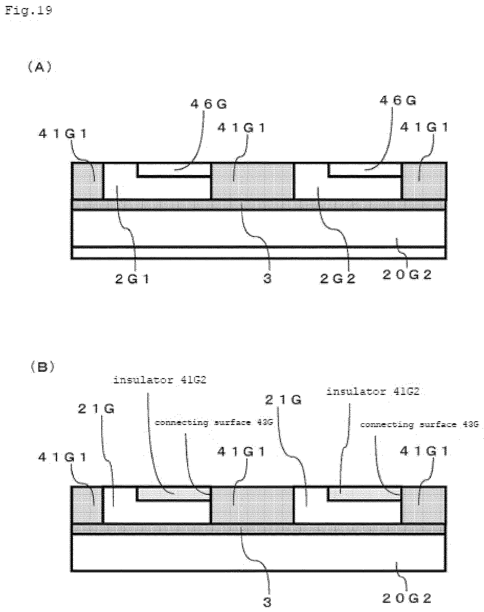

Next, in a state of being covered with the etching resist 26G in the second intermediate body resist forming process, the intermediate body 21G is etched (half-etched). This process is referred to as a second intermediate body etching process. Due to this process, a recessed portion 46G is formed in the intermediate body 21G as shown in Fig. 18(C). Then, the etching resist 26G provided in the second intermediate body resist process is removed, and enters a state shown in Fig. 19(A). In addition, due to this process, the thermal diffusion circuit 2G1 and the thermal diffusion circuit 2G2 are completed.

Next, as illustrated in Fig. 19(B), a process of filling the recessed portion 46G with an insulating resin is performed. This process is referred to as a recessed portion insulating resin filling process. Due to this process, the insulator 41G2 that is a support insulator is formed. In addition, due to this process, the connecting surface 43G is formed.

In addition, the rolled conductor 20G2 functions as the support member 81.

Note that, after the recessed portion insulating resin filling process, the upper-side surface may be subjected to a scrubbing treatment so that surfaces of the insulator 41G2 (insulating resin), the thermal diffusion circuits 2G1 and 2G2, and the insulator 41G1 become flat surfaces. This process is referred to as a fourth scrubbing process.

Then, a solder resist is provided on the upper-side surface and the lower-side surface of the substrate 1G to protect the substrate surfaces, or a heat dissipation member such as a heat sink is provided on the lower side of the support member 81 to further improve heat dissipation efficiency of the substrate in a similar manner as in the first embodiment. In addition, the electronic component 5 and the wires 61 and 62 are disposed to obtain an electronic device.

Note that, in this embodiment, in the first intermediate body resist forming process and the second intermediate body resist forming process, a case where the entirety of the rolled conductor 20G2 is covered with the etching resist is exemplified, but a part of the rolled conductor 20G2 may be etched so that the rolled conductor 20G2 remains as the support member 81 for supporting the thermal diffusion circuit 2G1 and the thermal diffusion circuit 2G2 across these circuits.

In addition, in this embodiment, the insulator 3 may be an insulating sheet made of an insulating resin that does not contain glass fibers, or a plate-shaped insulator (prepreg in the related art) made of a sheet-shaped reinforcing material obtained by knitting glass fibers and an insulating resin. In a case of the insulating sheet made of the insulating resin, since the glass fibers are not contained, there is an effect of reducing the weight of the substrate, and when being filled with thermal conductive fillers, there is an effect of raising the heat dissipation property. In addition, in a case of the plate-shaped insulator made of the sheet-shaped reinforcing material obtained by knitting glass fibers and the insulating resin, there is an effect of raising rigidity of the substrate.

In addition, in this embodiment, a case of the substrate 1G including two thermal diffusion circuits is exemplified, but the substrate 1G may include one (single) thermal diffusion circuit, or three or more thermal diffusion circuits.

### INDUSTRIAL APPLICABILITY

The electronic device of the invention is an electronic device provided with a substrate of the invention, and applications thereof are not particularly limited, but examples thereof include automobiles, aircrafts, unmanned aerial vehicles, mobile phones, smartphones, personal computers, LED modules, power semiconductor modules, and the like. According to the electronic device and the substrate, the heat dissipation performance of the electronic component can be improved.

### EXPLANATIONS OF LETTERS OR NUMERALS

- 1A: SUBSTRATE
- 1B: SUBSTRATE
- 1C: SUBSTRATE
- 1D: SUBSTRATE
- 1E: SUBSTRATE
- 2: THERMAL DIFFUSION CIRCUIT
- 3: INSULATOR
- 5: ELECTRONIC COMPONENT
- 7: ELECTRIC CIRCUIT
- 20: ROLLED CONDUCTOR
- 21: FIRST BASE
- 22: SECOND BASE
- 25: ETCHING RESIST
- 26: ETCHING RESIST
- 27: ETCHING RESIST
- 28: BASE MEMBER
- 41: INSULATOR
- 42: INSULATOR
- 43: CONNECTING SURFACE
- 45: RECESSED PORTION
- 46: RECESSED PORTION
- 61: WIRE
- 62: WIRE
- 70: CONDUCTOR
- 71: ANOTHER CIRCUIT
- 72: LOWER SURFACE SIDE CONDUCTOR
- 211: FIRST BASE UPPER PORTION
- 212: FIRST BASE LOWER PORTION
- 221: SECOND BASE UPPER PORTION
- 222: SECOND BASE LOWER PORTION
- 281: BASE MEMBER UPPER PORTION
- 282: BASE MEMBER LOWER PORTION
- 283: BASE MEMBER CENTRAL PORTION

## Claims

1. A substrate comprising:
a thermal diffusion circuit configured to cause heat to flow by using a temperature difference; and
an insulator,
wherein the thermal diffusion circuit includes a first base and a second base,
the first base and the second base have an integral structure without a connecting surface,
the first base is disposed on a side where an electronic component is disposed,
the second base is disposed on a side opposite to the side where the electronic component is disposed,
the second base has a structure extending beyond the first base in a planar direction, and
the insulator is disposed on a side of the first base where the electronic component is disposed.

2. The substrate according to claim 1,
wherein an electric circuit configured to supply electricity to the electronic component is disposed on a side of the insulator where the electronic component is disposed in contact with the insulator.

3. A substrate comprising:
a thermal diffusion circuit configured to cause heat to flow by using a temperature difference; and
an insulator,
wherein the thermal diffusion circuit includes a first base and a second base,
the first base and the second base have an integral structure without a connecting surface,
the first base is disposed on a side where an electronic component is disposed,
the second base is disposed on a side opposite to the side where the electronic component is disposed,
the second base has a structure extending beyond the first base in a planar direction, and
the insulator is disposed on a side of the second base which is opposite to the side where the electronic component is disposed.

4. A substrate comprising:
a thermal diffusion circuit configured to cause heat to flow by using a temperature difference;
an electric circuit configured to supply electricity to an electronic component; and
an insulator,
wherein the thermal diffusion circuit includes a first base and a second base,
the first base and the second base have an integral structure without a connecting surface,
the first base is disposed on a side where the electronic component is disposed,
the second base is disposed on a side opposite to the side where the electronic component is disposed,
the second base has a structure extending beyond the first base in a planar direction,
the insulator is disposed on a side of the second base which is opposite to the side where the electronic component is disposed, and
the electric circuit is disposed on a side of the thermal diffusion circuit where the electronic component is disposed.

5. A substrate comprising:
a thermal diffusion circuit configured to cause heat to flow by using a temperature difference;
an insulator; and
an electric circuit configured to supply electricity to an electronic component,
wherein the thermal diffusion circuit is a columnar base member,
the electric circuit is disposed on one side of the base member in a contact state, and
the insulator is disposed on the other side of the base member in a contact state.

6. A substrate comprising:
one thermal diffusion circuit configured to cause heat to flow by using a temperature difference;
the other thermal diffusion circuit;
a support member; and
an insulator,
wherein the one thermal diffusion circuit includes one first base and one second base,
the one first base and the one second base have an integral structure without a connecting surface,
the one first base is disposed on a side where an electronic component is disposed,
the one second base is disposed on a side opposite to the side where the electronic component is disposed,
the one second base has a structure extending beyond the one first base in a planar direction,
the other thermal diffusion circuit includes the other first base and the other second base,
the other first base and the other second base have an integral structure without a connecting surface,
the other first base is disposed on the side where the electronic component is disposed,
the other second base is disposed on a side opposite to the side where the electronic component is disposed,
the other second base has a structure extending beyond the other first base in the planar direction,
the insulator is disposed on a side of the one second base and the other second base which is opposite to the side where the electronic component is disposed, and
the support member is disposed across the one second base and the other second base via the insulator.

7. An electronic device comprising:
the substrate according to claim 1 or 2; and
an electronic component,
wherein the insulator is interposed between the first base and the electronic component.

8. An electronic device comprising:
the substrate according to any one of claims 3 to 6; and
an electronic component,
wherein the insulator is not provided between the first base and the electronic component, or between the base member and the electronic component.
